# EUROPEAN PATENT APPLICATION

(11) **EP 4 788 067 A1**
(43) Date of publication of application: **05.08.2026**
(21) Application number: 23954290.5
(22) Date of filing: 28.09.2023
(51) Int. Cl.: H05K 3/10, B29C 64/20, B41J 2/01

(54) **PRINTING DEVICE AND PRINTING SYSTEM**

(71) Applicant: Fuji Corporation, Chiryu-shi, Aichi 472-8686 (JP)
(72) Inventor: MORIKAWA, Shunji, Chiryu-shi, Aichi 472-8686 (JP); TOMINAGA, Ryojiro, Chiryu-shi, Aichi 472-8686 (JP); KAWAJIRI, Akihiro, Chiryu-shi, Aichi 472-8686 (JP); MATSUYAMA, Kazuki, Chiryu-shi, Aichi 472-8686 (JP); SUZUKI, Jun, Chiryu-shi, Aichi 472-8686 (JP); OKAMOTO, Kazumasa, Chiryu-shi, Aichi 472-8686 (JP)
(74) Representative: Grünecker Patent- und Rechtsanwälte PartG mbB
(86) International application number: PCT/JP2023/035447
(87) International publication number: WO 2025/069318

(57) **Abstract**

A printing device of the present disclosure relates to a printing device for fabricating a fabricated object having wiring, the printing device including: a housing that accommodates multiple units, the housing having a mounting device disposed adjacent to one side surface and configured to mount a component on the fabricated object, in which a movement opening through which an object on which the fabricated object is placed is moved between the housing and the mounting device is formed on the one side surface of the housing, and an opening and closing door configured to maintain any of the multiple units is disposed on at least a front surface and a side surface opposite to the one side surface of the housing.

## Description

### Technical Field

The present description discloses a printing device and a printing system.

### Background Art

Conventionally, there has been proposed a printing device including a control module, a holding module that holds a workpiece, and a work module that executes work on the workpiece, in which the control module includes a communication section that communicates with each of the holding module and the work module, and a common interface that supplies power to both the holding module and the work module (for example, see Patent Literature 1). It is stated that this device makes it possible to provide a manufacturing work device capable of easily changing the content, quality, and the like of executable work.

### Citation List

### Patent Literature

Patent Literature 1: JP-A-2019-75466

### Summary of the Invention

### Technical Problem

In the printing device disclosed in Patent Literature 1, a cover module is provided with a door body that is openably and closably held so as to be movable between a closed position at which a penetrating portion is closed and an open position at which the penetrating portion is opened, and an inner space of the work module is accessible through the penetrating portion of a frame body in a state where the door body is in the open position. However, in the printing device of Patent Literature 1, maintenance of units disposed inside a housing has not been sufficiently considered. As described above, it has been desired to improve the maintenance efficiency of the units provided in the printing device.

The present disclosure has been made to solve such a problem, and a main object thereof is to provide a printing device and a printing system capable of further improving the efficiency of maintenance work.

The present disclosure employs the following means in order to achieve the above-mentioned main object.

A printing device disclosed in the present description is
a printing device for fabricating a fabricated object having wiring, the printing device including:
a housing that accommodates multiple units, the housing having a mounting device configured to mount a component on the fabricated object disposed adjacent to a first side surface, in which
a movement opening through which an object on which the fabricated object is placed is moved between the housing and the mounting device is formed on the first side surface of the housing, and
an opening and closing door configured to maintain any of the multiple units is disposed on at least a front surface and a side surface opposite to the first side surface of the housing.

In this printing device, since the opening and closing door corresponding to each unit is disposed on the front surface and the side surface different from the surface adjacent to the mounting device, a worker can easily access a unit serving as a maintenance target, and the efficiency of the maintenance work can be further improved.

### Brief Description of Drawings

Fig. 1 is a schematic diagram illustrating an example of printing system 10.
Fig. 2 is a schematic diagram illustrating an example of a structure of three-dimensional printer 11 viewed from the front.
Fig. 3 is a schematic diagram illustrating an example of a structure of three-dimensional printer 11 viewed from the rear.
Fig. 4 is a diagram illustrating an example of a schematic configuration of first discharge unit 50.
Fig. 5 is a diagram of each discharge unit, moving unit 44, and housing air blowing section 142.
Fig. 6 is a diagram illustrating an example of a schematic configuration of dispenser unit 100.
Fig. 7 is a diagram illustrating an example of a schematic configuration of opening and closing door 130.
Fig. 8 is a perspective view of mounting module 36 and third sliding door 134 in a slid state.
Fig. 9 is a perspective view of mounting module 36 and third sliding door 134 in a slid state.
Fig. 10 is a diagram illustrating an example of an inside of fabricating module 15.
Fig. 11 is a diagram illustrating an example of operation panel 48 and opening/closing unit 125.
Fig. 12 is a diagram illustrating an example of an internal structure of fabricating base 14.
Fig. 13 is a diagram of an inside of housing 13 and air blowing unit 140.
Fig. 14 is a block diagram illustrating a configuration of three-dimensional printer 11.
Fig. 15 is a flowchart illustrating an example of a fabricated object production process routine.

### Description of Embodiments

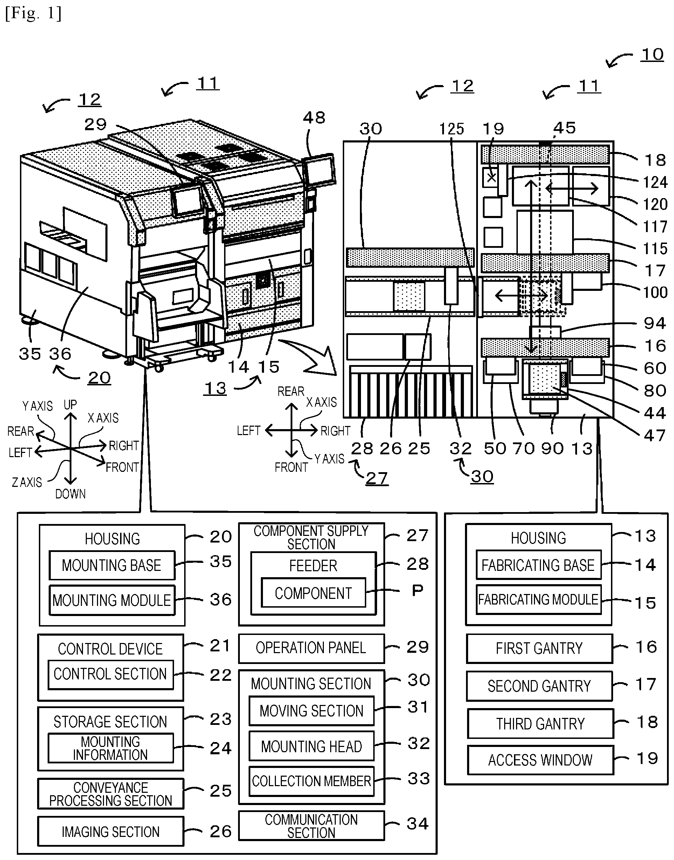

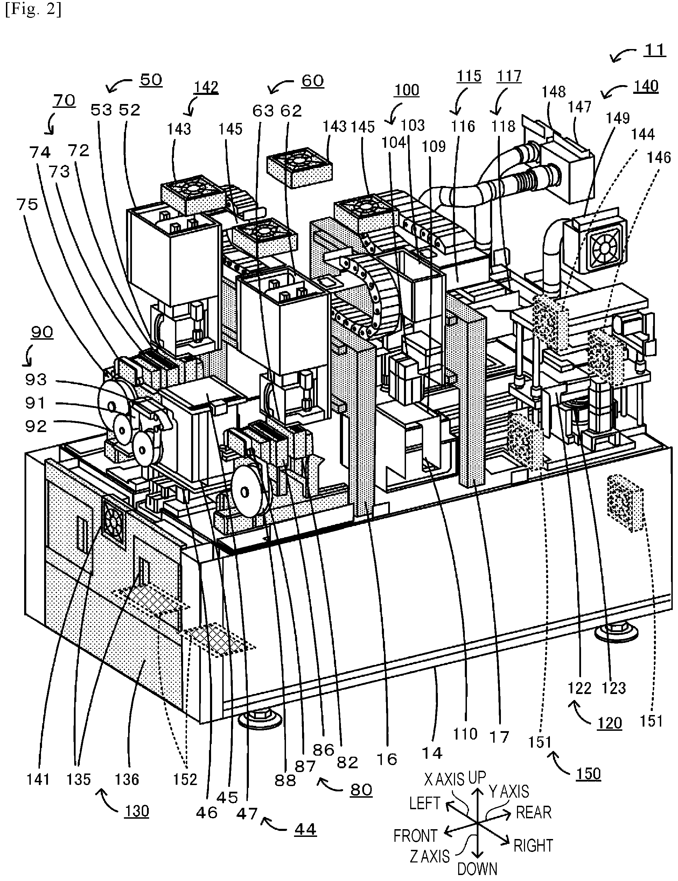

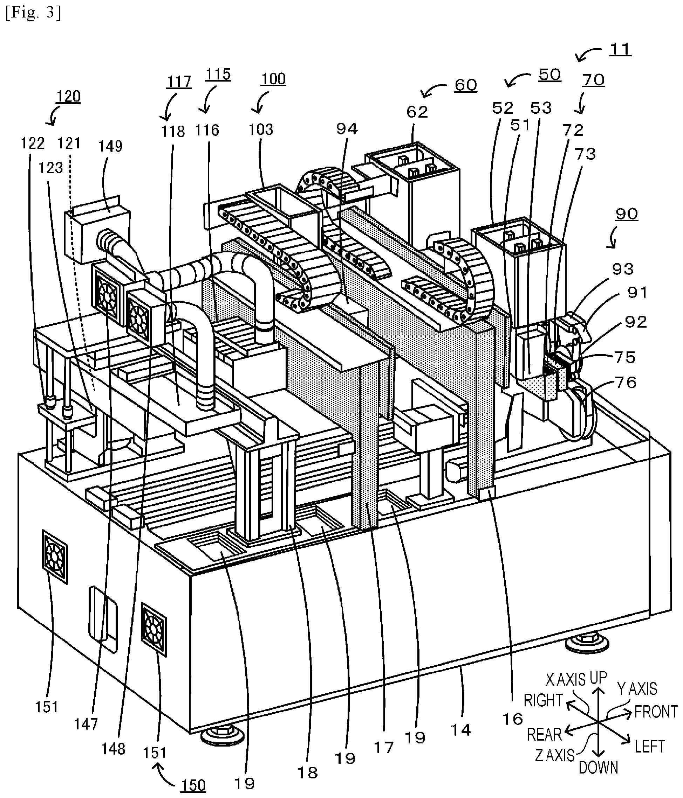

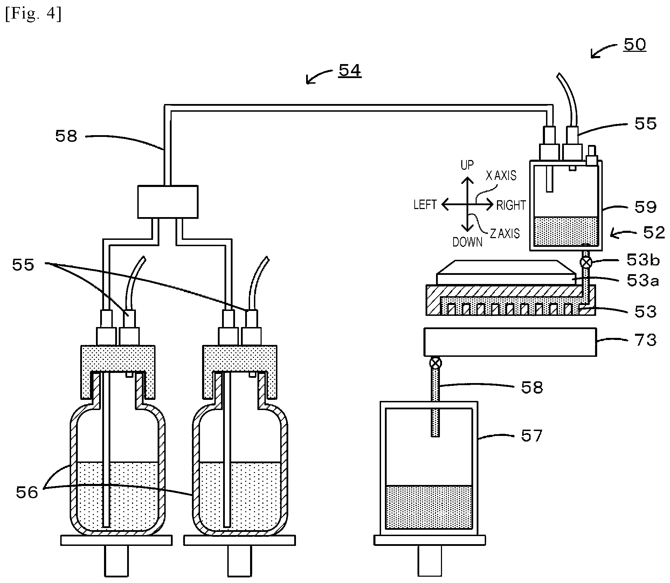

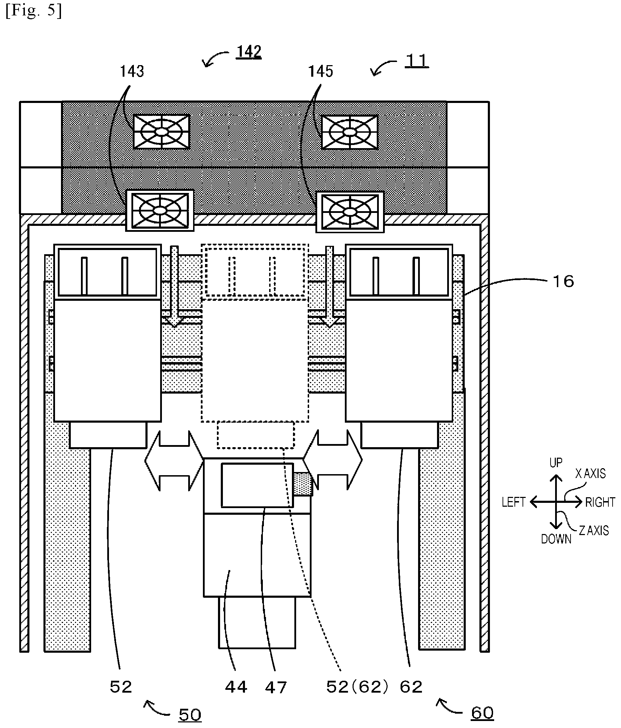

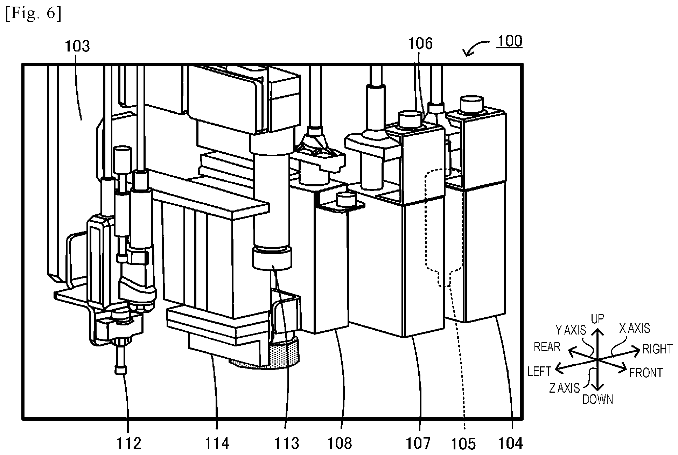

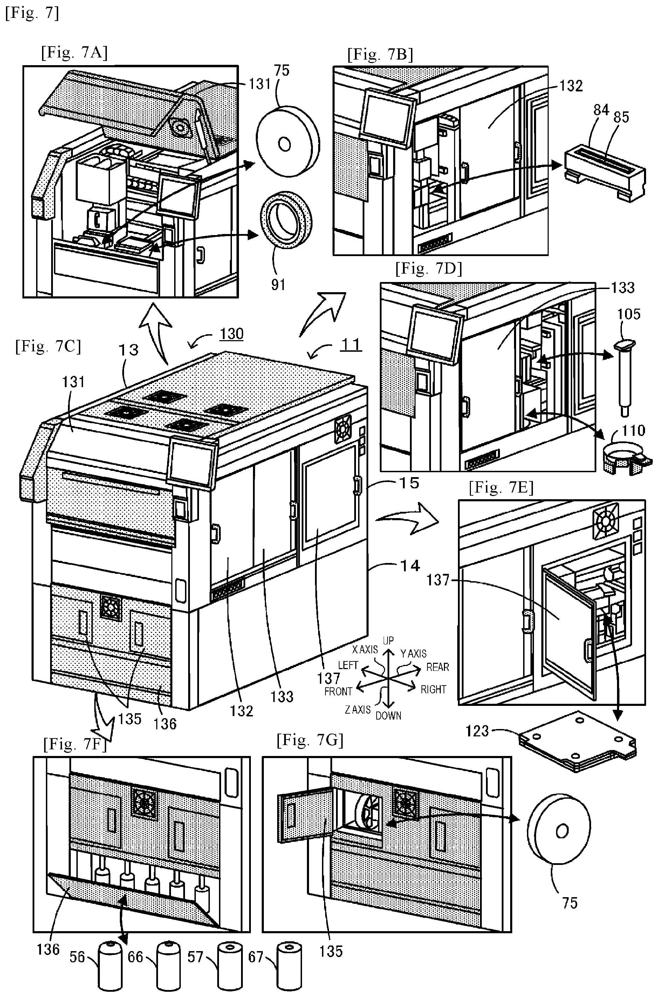

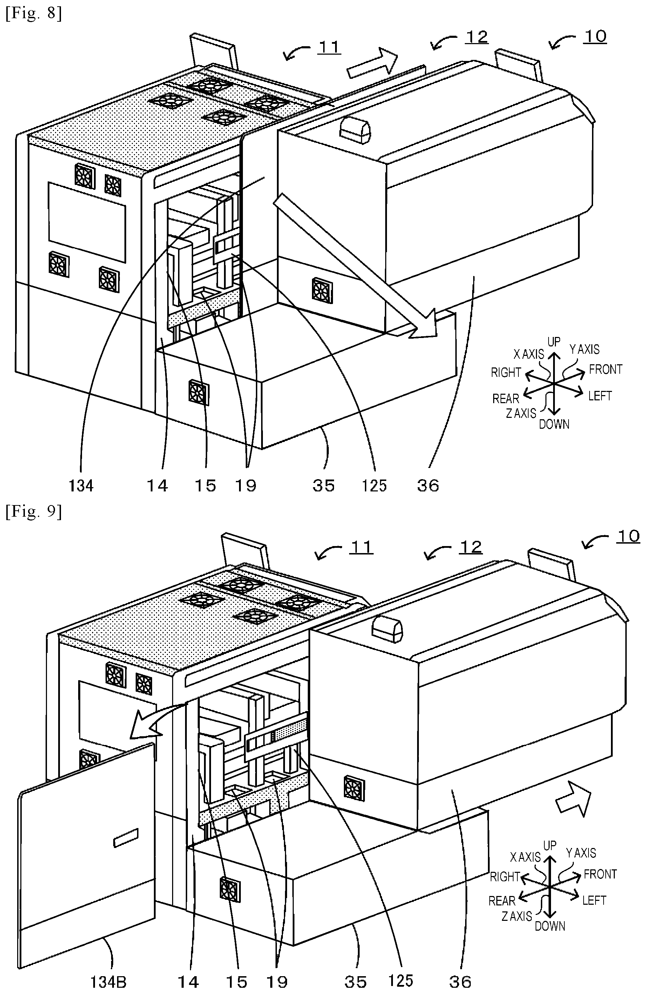

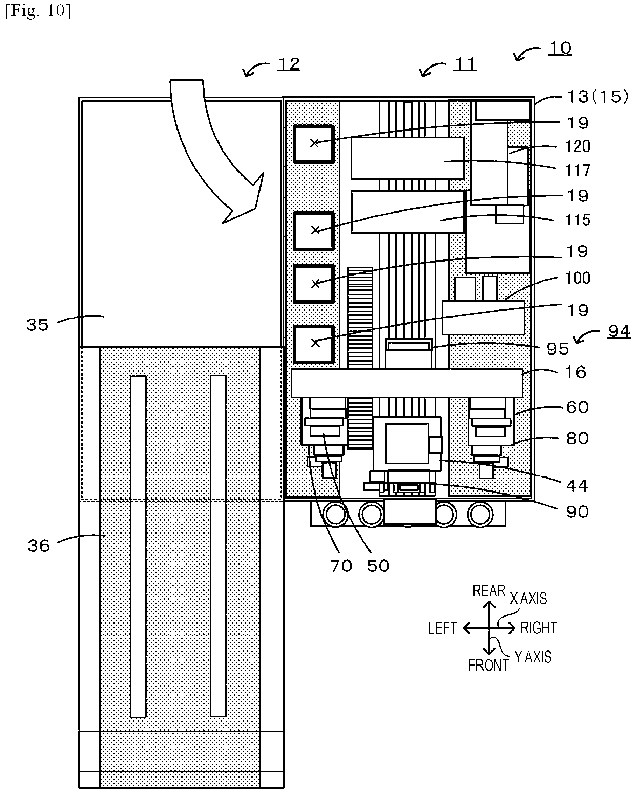

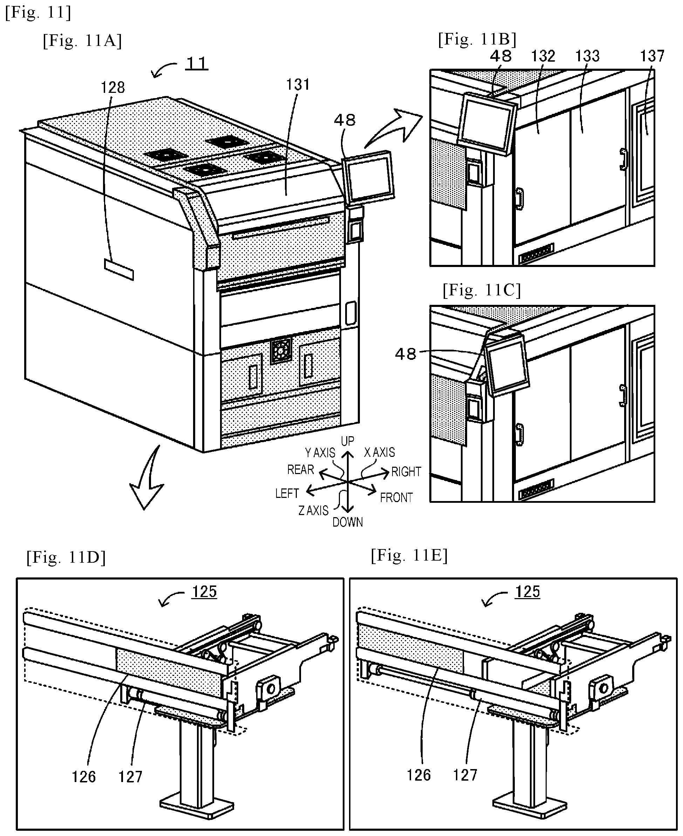

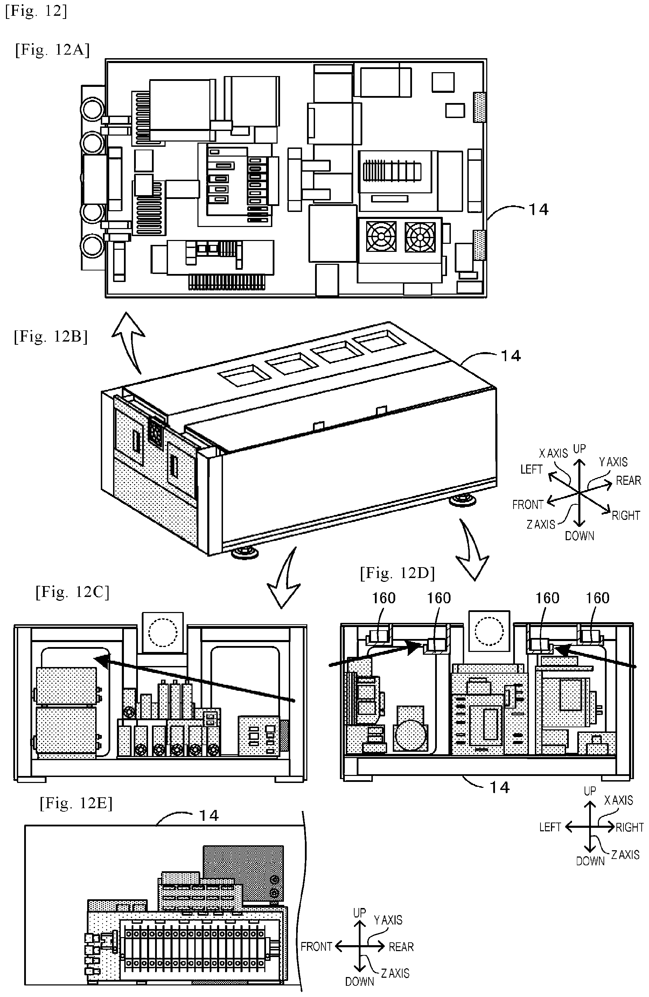

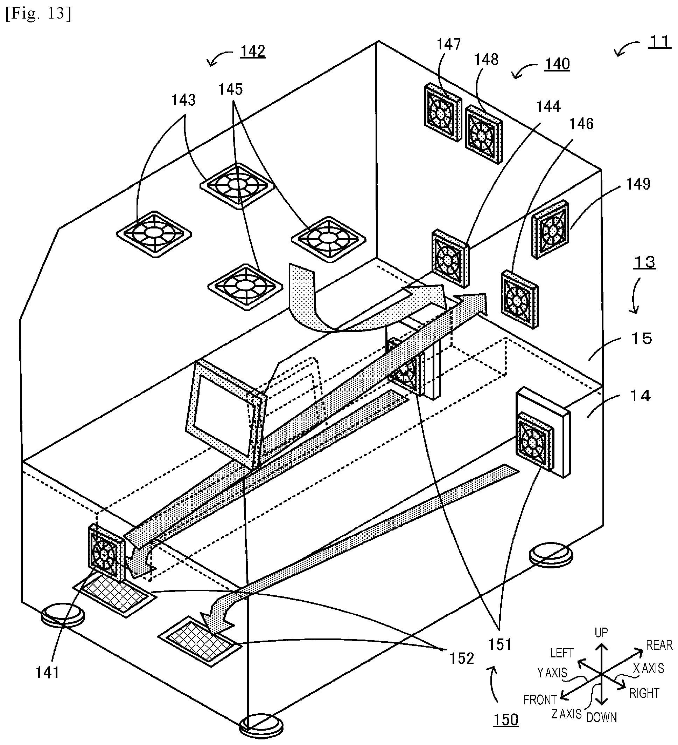

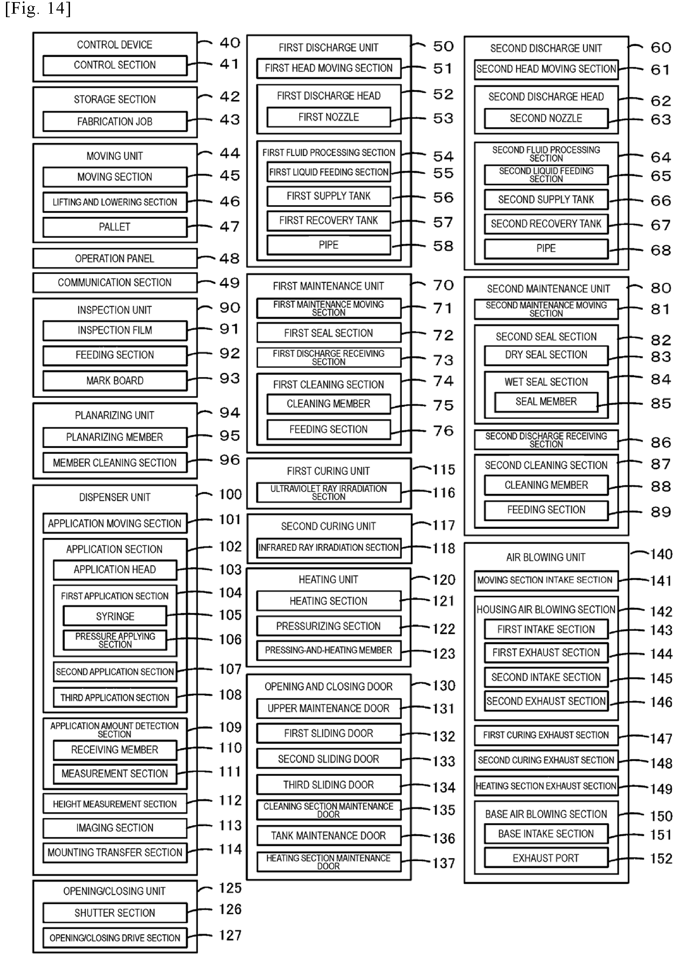

The present embodiment will be described below with reference to the accompanying drawings. Fig. 1 is a schematic diagram illustrating an example of printing system 10 that is an example of the present disclosure. Fig. 2 is a schematic diagram illustrating an example of a structure of three-dimensional printer 11 viewed from the front. Fig. 3 is a schematic diagram illustrating an example of a structure of three-dimensional printer 11 viewed from the rear. Fig. 4 is a diagram illustrating an example of a schematic configuration of first discharge unit 50. Fig. 5 is a diagram of first discharge unit 50, second discharge unit 60, moving unit 44, and housing air blowing section 142. Fig. 6 is a diagram illustrating an example of a schematic configuration of dispenser unit 100. Fig. 7 is a diagram illustrating an example of a schematic configuration of opening and closing door 130, in which Fig. 7A is a diagram of upper maintenance door 131, Fig. 7B is a diagram of first sliding door 132, Fig. 7C is a perspective view of three-dimensional printer 11, Fig. 7D is a diagram of second sliding door 133, Fig. 7E is a diagram of heating section maintenance door 137, Fig. 7F is a diagram of tank maintenance door 136, and Fig. 7G is a diagram of cleaning section maintenance door 135. Fig. 8 is a perspective view of mounting module 36 and third sliding door 134 in a state where mounting module 36 is slid forward and third sliding door 134 is slid rearward. Fig. 9 is a perspective view of mounting module 36 and third sliding door 134 in a forward slid state. Fig. 10 is a diagram illustrating an example of the inside of fabricating module 15 when mounting module 36 is slid forward. Fig. 11 is a diagram illustrating an example of operation panel 48 and opening/closing unit 125, in which Fig. 11A is a perspective view of three-dimensional printer 11, Fig. 11B is a diagram of operation panel 48 facing the front, Fig. 11C is a diagram of operation panel 48 facing the side, Fig. 11D is a diagram of opening/closing unit 125 in a closed position, and Fig. 11E is a diagram of opening/closing unit 125 in an open position. Fig. 12 is a diagram illustrating an example of an internal structure of fabricating base 14, in which Fig. 12A is a plan view of the interior, Fig. 12B is a perspective view, Fig. 12C is a front view of the front interior, Fig. 12D is a front view of the rear interior, and Fig. 12E is a side view of the front interior. Fig. 13 is a diagram of the inside of housing 13 and air blowing unit 140. Fig. 14 is a block diagram illustrating a configuration of three-dimensional printer 11. In the present embodiment, a left-right direction (X axis), a front-rear direction (Y axis), and an up-down direction (Z axis) are as illustrated in Figs. 1 to 13.

Printing system 10 is configured as a production line in which three-dimensional printer 11 fabricates a fabricated object as a first process and, after forming a predetermined member on the fabricated object as a second process, mounting device 12 performs a component mounting process. Three-dimensional printer 11 may form a wiring pattern of metal wiring as the second process, and mounting device 12 may execute a process of mounting a component at a predetermined position of the wiring pattern. In addition to mounting device 12, printing system 10 may also include one or more mounting-related devices such as a printing device that prints solder as viscous fluid onto the fabricated object, a printing inspection device that inspects the printing results, a mounting inspection device that inspects the mounting results, and a conveyance device that conveys the fabricated object that is fabricated. In addition, three-dimensional printer 11 or mounting device 12 may include a dispenser that discharges a conductive paste. Examples of the conductive paste include a conductive paste in which metal particles are dispersed in a resin that is cured by heating. For example, in the conductive paste, when the resin is cured and shrinks, the metal particles dispersed in the resin come into contact with each other. As a result, the conductive paste exhibits conductivity. The resin of the conductive paste is, for example, an organic adhesive, and exhibits an adhesive force by being cured. Printing system 10 illustrated in Fig. 1 includes one mounting device 12, but may include multiple mounting devices 12. In this case, in printing system 10, it is preferable from the viewpoint of maintenance to arrange mounting devices 12, that is, to dispose mounting devices 12 on a first side surface of three-dimensional printer 11 and not to dispose mounting devices 12 on a second side surface.

Mounting device 12 is a device that mounts a component on the fabricated object that is fabricated by three-dimensional printer 11. Mounting device 12 includes housing 20, control device 21, storage section 23, conveyance processing section 25, imaging section 26, component supply section 27, operation panel 29, mounting section 30, and communication section 34. Housing 20 accommodates each device configuration, and includes mounting base 35 and mounting module 36. Mounting base 35 is a pedestal of the device, and accommodates a control unit such as control device 21, a power control unit such as a power supply device or an amplifier, a pressure circuit that supplies negative pressure, positive pressure, or the like to each unit, and the like. Mounting module 36 is disposed above mounting base 35, and accommodates various units that execute the mounting process, such as conveyance processing section 25, imaging section 26, component supply section 27, and mounting section 30. As illustrated in Figs. 8 to 10, mounting module 36 is supported slidably along a side surface of housing 20 with respect to mounting base 35 between a mounting position located at the top of mounting base 35 and an open position where the inside of mounting base 35 is open.

Control device 21 is configured as a microprocessor mainly including control section 22 such as CPU, and controls the entire device. Control device 21 outputs control signals to conveyance processing section 25, imaging section 26, component supply section 27, operation panel 29, and mounting section 30, and receives signals from conveyance processing section 25, imaging section 26, component supply section 27, operation panel 29, and mounting section 30. Storage section 23 is, for example, a large-capacity storage medium such as a flash memory. Storage section 23 stores mounting information 24 including information on component P to be mounted or information on an arrangement order in which components P are mounted on the fabricated object, their arrangement positions, or a mounting position of feeder 28 that picks up component P. Conveyance processing section 25 carries in and conveys pallet 47 on which the fabricated object is placed, and fixes and carries out pallet 47 at the mounting position. Imaging section 26 is a camera that captures an image of an upward region, and captures an image of component P or the like held by mounting head 32 of mounting section 30. Component supply section 27 is a unit that supplies component P to mounting section 30. Component supply section 27 mounts feeder 28 having a reel holding components on one or more mounting sections. Operation panel 29 is a unit that receives input from the worker and that presents information to the worker. Operation panel 29 is disposed on a front surface of mounting device 12, and includes a display section serving as a display and an operation section having a touch panel and buttons.

Mounting section 30 is a unit that picks up component P from component supply section 27 and that places component P on the fabricated object fixed to conveyance processing section 25. Mounting section 30 includes head moving section 31, mounting head 32, and collection member 33. Head moving section 31 includes a slider that is guided by a guide rail and moves in X and Y directions, and a motor that drives the slider. Mounting head 32 is removably mounted on the slider, picks up one or more components, and is moved in the X and Y directions by head moving section 31. One or more collection members 33 are removably mounted on a lower surface of mounting head 32. Collection member 33 may be a suction nozzle that picks up the component by using negative pressure, or may be a mechanical chuck that mechanically holds the component. Communication section 34 is an interface for exchanging information with external devices such as three-dimensional printer 11 and a management device (not illustrated).

Three-dimensional printer 11 is a three-dimensional fabricating device that fabricates a fabricated object. A fabricating material is not particularly limited, and examples thereof include resins and ceramics. Three-dimensional printer 11 includes control device 40, storage section 42, moving unit 44, operation panel 48, communication section 49, first discharge unit 50, second discharge unit 60, first maintenance unit 70, second maintenance unit 80, inspection unit 90, planarizing unit 94, dispenser unit 100, first curing unit 115, second curing unit 117, heating unit 120, opening and closing door 130, and air blowing unit 140. In addition, three-dimensional printer 11 includes, as structures, housing 13, first gantry 16, second gantry 17, and third gantry 18. Here, three-dimensional printer 11 will be mainly described as a printer that uses first discharge unit 50 to fabricate an insulator, such as a board as a base material for the fabricated object, and then uses second discharge unit 60 to execute a process of forming a wiring pattern on the fabricated insulator.

Housing 13 has mounting device 12 that is disposed adjacent to one side surface and that mounts a component on the fabricated object, and accommodates multiple units. On the one side surface of housing 13, movement opening 128 through which pallet 47 serving as an object on which the fabricated object is placed is moved between housing 13 and mounting device 12 is formed (see Fig. 11). Opening and closing door 130 for maintaining any of the multiple units is disposed on at least a front surface of housing 13 and a side surface opposite to one side surface adjacent to mounting device 12. Although a specific example in which movement opening 128 is formed on a left side surface of housing 13 is described here, movement opening 128 may be formed on a right side surface of housing 13. Housing 13 includes fabricating base 14 serving as a pedestal, and fabricating module 15 that is disposed above fabricating base 14 and that accommodates multiple units. Fabricating base 14 accommodates a power control unit such as a power supply device and an amplifier, a pressure circuit that supplies negative pressure, positive pressure, and the like to each unit, and the like. Fabricating module 15 is disposed above fabricating base 14 and accommodates various units that execute a fabricating process, such as first discharge unit 50, second discharge unit 60, first maintenance unit 70, second maintenance unit 80, inspection unit 90, planarizing unit 94, dispenser unit 100, first curing unit 115, second curing unit 117, heating unit 120, and the like.

As illustrated in Figs. 2 and 3, first gantry 16 is fixed to a front-side region of housing 13. First gantry 16 is a gate-shaped support body that includes two support columns fixed to both sides of the side surface of housing 13 and a horizontal member stretched between the two support columns and that supports the units. On first gantry 16, first discharge unit 50 and second discharge unit 60 are disposed so as to be movable in the left-right direction along the X axis. On first gantry 16, first discharge unit 50 is disposed on one side surface side adjacent to mounting device 12, and second discharge unit 60 is disposed on the opposite side surface side. Since first discharge unit 50 and second discharge unit 60 are supported by the same support body, the expansion and contraction of the support body occur in the same manner, thereby achieving more uniform discharge accuracy. Second gantry 17 is fixed to a central region of housing 13 in the front-rear direction. Dispenser unit 100 is disposed on second gantry 17 so as to be movable in the left-right direction along the X axis. Third gantry 18 is fixed to a rear-side region of housing 13. First curing unit 115 and second curing unit 117 are fixed to third gantry 18. Pallet 47 is moved by moving unit 44 below first gantry 16, second gantry 17, and third gantry 18 in the front-rear direction along the Y axis.

Control device 40 is configured as a microprocessor mainly including control section 41, and performs overall control of three-dimensional printer 11. Control device 40 exchanges information with storage section 42 and each unit. Storage section 42 is, for example, a large-capacity storage medium such as a flash memory. Storage section 42 stores fabrication job 43 including information such as a shape and a size of a fabricated object to be manufactured and information such as a wiring pattern formed on the fabricated object. Three-dimensional printer 11 executes fabricating work based on the information stored in storage section 42.

Moving unit 44 moves pallet 47 serving as an object onto which fluid is discharged. Moving unit 44 includes moving section 45, lifting and lowering section 46, and pallet 47. Moving section 45 is a drive section that moves pallet 47 along the front-rear direction, and may be, for example, a linear motor. Moving section 45 may be a ball screw mechanism including a motor, a screw shaft, a nut, and a housing. Lifting and lowering section 46 is disposed on moving section 45, supports pallet 47, and moves pallet 47 in the up-down direction. Lifting and lowering section 46 moves pallet 47 toward and away from various units by lifting and lowering pallet 47. Pallet 47 is a plate-shaped member having a region for fabricating a fabricated object. A removable film is attached to an upper surface of pallet 47, and by replacing the film, the next fabricated object can be manufactured.

Operation panel 48 is a unit that receives input from the worker and that presents information to the worker. As illustrated in Figs. 1 and 11, operation panel 48 is disposed on a front surface of housing 13, and includes a display section serving as a display and an operation section having a touch panel and buttons. In addition, as illustrated in Figs. 11B and 11C, operation panel 48 is supported by a support portion that is rotatable so that a display surface faces the front surface of housing 13 on which upper maintenance door 131 is disposed and the side surface of housing 13. In three-dimensional printer 11, the worker may execute the maintenance work on the side surface side in addition to the front surface side. Since operation panel 48 rotates toward the front surface side and the side surface side, the worker can check the display of operation panel 48 and perform operation inputs at any position, thereby facilitating the maintenance work.

First discharge unit 50 is a unit that discharges fluid for forming a structure onto pallet 47. As illustrated in Figs. 2 and 3, first discharge unit 50 is disposed in the front-side region of housing 13 and on a left side of housing 13, which is the side surface side adjacent to mounting device 12. As illustrated in Figs. 4 and 14, first discharge unit 50 includes first head moving section 51, first discharge head 52, and first fluid processing section 54. First head moving section 51 includes a slider that is guided by a guide rail disposed on first gantry 16 and moves along the X axis direction, and a motor that drives the slider. First discharge head 52 is mounted on the slider, and first discharge head 52 moves in the X axis direction along with the movement of the slider. As illustrated in Fig. 5, first head moving section 51 moves first discharge head 52 between a working position, which is on the top of pallet 47 located in a central region of housing 13 along the X axis, and a standby position located on the side surface side on mounting device 12 side.

First discharge head 52 discharges fluid onto pallet 47 to fabricate a fabricated object. As illustrated in Fig. 4, first discharge head 52 includes first nozzle 53, discharge drive section 53a, and head tank 59. First nozzle 53 is an opening hole through which fluid supplied from first fluid processing section 54 is discharged onto pallet 47. First nozzles 53 are formed at predetermined intervals on a nozzle plate disposed on a lower surface side of first discharge head 52. Discharge drive section 53a discharges, for example, the fluid to pallet 47, and examples thereof include a piezoelectric element. Discharge drive section 53a is provided for each first nozzle 53 and is driven based on a signal from control device 40. Head tank 59 is a tank disposed in first discharge head 52 that stores the fluid fed from first fluid processing section 54. Examples of the fluid discharged by first nozzle 53 include a liquid curable resin (such as an ultraviolet curable resin, a thermosetting resin, or a two-component mixed curable resin), a thermoplastic resin, and a slurry obtained by mixing a solid material such as an inorganic material with a solvent. First discharge head 52 has no wall portion on a ceiling surface, and is configured to cause allow airflow to pass through in the up-down direction.

First fluid processing section 54 is disposed in the front-side region of housing 13, supplies fluid to first discharge head 52, and recovers fluid to be discarded. First fluid processing section 54 includes first liquid feeding section 55 that performs liquid feeding in first discharge head 52, first supply tank 56 that supplies fluid, first recovery tank 57 that stores recovered fluid, and pipe 58 disposed between the respective components. First liquid feeding section 55 is connected to a pressure supply section (not illustrated), and supplies positive pressure or negative pressure to head tank 59 to move the fluid between first supply tank 56 and head tank 59 or between head tank 59 and first nozzle 53. For example, when first liquid feeding section 55 applies positive pressure to head tank 59 in a state where first nozzle 53 is sealed by liquid valve 53b, the fluid in pipe 58 connected to an upper portion of head tank 59 is fed to first supply tank 56 side. In addition, when first liquid feeding section 55 applies negative pressure to head tank 59 in a state where first nozzle 53 is sealed by liquid valve 53b, the fluid is fed from first supply tank 56 to head tank 59 side via pipe 58 connected to the upper portion of head tank 59. First supply tank 56 is a container that stores fluid. In first fluid processing section 54, multiple first supply tanks 56 are disposed, and these are switched and used. When first supply tank 56 becomes empty, the worker exchanges empty first supply tank 56, for example, while continuing fabrication using another first supply tank 56. First discharge unit 50 allows for continuous fabrication for a longer period of time. First recovery tank 57 is a container for recovering used fluid. First supply tank 56 and first recovery tank 57 are removably disposed in the front-side region and on a lower side of housing 13. Pipe 58 is a pipe connecting first discharge head 52 and first supply tank 56 or a pipe connecting first discharge receiving section 73 and first recovery tank 57, and fluid flows through the inside of pipe 58.

Second discharge unit 60 is a unit that discharges fluid for forming wiring to be formed inside or on the surface of the fabricated object onto pallet 47 or the fabricated object. As illustrated in Figs. 2 and 3, second discharge unit 60 is disposed in the front-side region of housing 13 and on a right side of housing 13, which is the side surface side opposite to the side surface side adjacent to mounting device 12. As illustrated in Fig. 14, second discharge unit 60 includes second head moving section 61, second discharge head 62, and second fluid processing section 64. Second head moving section 61 includes a slider that is guided by a guide rail disposed on first gantry 16 and moves along the X axis direction, and a motor that drives the slider. Second discharge head 62 is mounted on the slider, and second discharge head 62 moves in the X axis direction along with the movement of the slider. As illustrated in Fig. 5, second head moving section 61 moves second discharge head 62 between a printing position, which is on the top of pallet 47 located in a central region of housing 13 along the X axis, and a standby position located on the side surface side opposite to mounting device 12 side.

Second discharge head 62 discharges fluid onto the fabricated object on pallet 47 to form wiring. Similarly to first discharge head 52 illustrated in Fig. 4, second discharge head 62 includes second nozzle 63, a discharge drive section, and a head tank. In second discharge head 62, components having the same structure and function as those of first discharge head 52, such as second nozzle 63, second fluid processing section 64, second liquid feeding section 65, second supply tank 66, second recovery tank 67, and pipe 68, are the same as first nozzle 53, first fluid processing section 54, first liquid feeding section 55, first supply tank 56, first recovery tank 57, and pipe 58, and detailed description thereof will be omitted. Examples of the fluid discharged from second nozzle 63 include a mixed liquid obtained by mixing a solid material with a solvent, and a solution obtained by dissolving a resin in a solvent. Examples of the fluid that forms the wiring pattern include a mixed liquid in which metal powder as a conductive material is dispersed in an organic solvent, and metal ink conductive fluid. Since second fluid processing section 64 is used less frequently than first supply tank 56, only one second supply tank 66 may be provided. In addition, as one of second supply tanks 66, second supply tank 66 containing a cleaning liquid such as a solvent may be used. The cleaning liquid may be fed from second supply tank 66 to the head tank of second discharge head 62 to clean second discharge head 62. Second discharge head 62 has no wall portion on a ceiling surface, and is configured to allow airflow to pass through in the up-down direction.

First maintenance unit 70 is a unit that protects first discharge head 52 and that performs discharge maintenance based on a discharge state of first discharge head 52. As illustrated in Figs. 2 and 3, first maintenance unit 70 is disposed in the front-side region of housing 13 and on the left side of housing 13, which is the side surface side adjacent to mounting device 12. As illustrated in Figs. 2 and 14, first maintenance unit 70 includes first maintenance moving section 71, first seal section 72, first discharge receiving section 73, and first cleaning section 74. First seal section 72, first discharge receiving section 73, and first cleaning section 74 of first maintenance unit 70 are arranged along the Y axis direction. First maintenance moving section 71 moves entire first maintenance unit 70 in the front-rear direction that is a direction along the Y axis. First maintenance moving section 71 moves first maintenance unit 70 between a maintenance position below first discharge unit 50 and a standby position away from below first discharge unit 50. First seal section 72 is a cap section that seals first nozzle 53 of first discharge head 52. First seal section 72 that seals first discharge head 52 may be a dry cap mechanism in which a seal space is not in a wet state. First discharge receiving section 73 is a member that receives fluid discharged from first discharge head 52, for example, in a flushing process. The fluid discharged to first discharge receiving section 73 is recovered to first recovery tank 57 via pipe 58. First cleaning section 74 wipes and cleans the nozzle plate on which first nozzles 53 are formed. First cleaning section 74 includes cleaning member 75 and feeding section 76. Cleaning member 75 may be wiping paper or the like. Cleaning member 75 is an elongated member that is drawn out from a pre-cleaning roll and is wound around a post-cleaning roll after passing over an upper portion of a cleaning head. The cleaning head comes into contact with and separates from first nozzle 53 by lifting and lowering. Feeding section 76 feeds cleaning member 75 from the pre-cleaning roll by rotationally driving the post-cleaning roll. As illustrated in Fig. 7G, the post-cleaning roll around which cleaning member 75 is wound is disposed in a lower portion of the front-side region of housing 13 and on the left side of housing 13, which is the side surface side adjacent to mounting device 12. Control device 40 uses first cleaning section 74 to execute the cleaning process periodically or as appropriate according to the degree of contamination of first discharge head 52.

Second maintenance unit 80 is a unit that protects second discharge head 62 and that performs discharge maintenance based on a discharge state of second discharge head 62. As illustrated in Figs. 2 and 3, second maintenance unit 80 is disposed in the front-side region of housing 13 and on the right side of housing 13, which is the side surface side opposite to the side surface adjacent to mounting device 12. As illustrated in Figs. 2 and 14, second maintenance unit 80 includes second maintenance moving section 81, second seal section 82, second discharge receiving section 86, and second cleaning section 87. Second seal section 82, second discharge receiving section 86, and second cleaning section 87 of second maintenance unit 80 are arranged along the Y axis direction. In second maintenance unit 80, components having the same structure and function as those of first maintenance unit 70, such as second maintenance moving section 81, second discharge receiving section 86, second cleaning section 87, cleaning member 88, and feeding section 89, are the same as first maintenance moving section 71, first discharge receiving section 73, first cleaning section 74, cleaning member 75, and feeding section 76, and detailed description thereof will be omitted. In second cleaning section 87, the post-cleaning roll around which cleaning member 75 is wound is disposed in a lower portion of the front-side region of housing 13 and on the right side of housing 13, which is a side opposite to a side surface adjacent to mounting device 12. Second seal section 82 is a cap section that seals second nozzle 63 of second discharge head 62 in which nozzle clogging due to drying is relatively likely to occur. Second seal section 82 that seals second discharge head 62 includes dry seal section 83 of a dry cap mechanism in which a seal space is not in a wet state, and wet seal section 84 of a wet cap mechanism in which a seal space is in a wet state. Dry seal section 83 is used to seal second discharge head 62 for a relatively short period of time such as several minutes. Wet seal section 84 is used to seal second discharge head 62 for a long period of time such as several hours or several days. Seal member 85 that absorbs a liquid and maintains a wet state is removably attached to wet seal section 84. Seal member 85 is periodically replaced. Control device 40 uses second cleaning section 87 to execute the cleaning process periodically or as appropriate according to the degree of contamination of second discharge head 62.

Inspection unit 90 is a unit that inspects the discharge state of first discharge unit 50 and/or second discharge unit 60. Inspection unit 90 is fixed in front of moving unit 44 on which pallet 47 is disposed, and more specifically, is fixed to a portion of moving unit 44 that supports pallet 47. Inspection unit 90 is movable back and forth along the Y axis direction together with pallet 47. When the portion of moving unit 44 that supports pallet 47 moves forward, inspection unit 90 can be disposed in the front-side region of housing 13. As illustrated in Figs. 2 and 14, inspection unit 90 includes inspection film 91, feeding section 92, and mark board 93. Inspection unit 90 causes fluid to land on a surface of inspection film 91 fixed on mark board 93, and by feeding inspection film 91, omits a process such as cleaning of mark board 93, thereby enabling multiple discharge inspections to be performed efficiently. Inspection film 91 is preferably, for example, a transparent resin film, and the material and film thickness thereof can be determined as appropriate so as to facilitate the discharge inspection. Inspection film 91 is an elongated member that is drawn out from a pre-inspection roll and is wound around a post-inspection roll after passing over an upper portion of mark board 93. Feeding section 92 feeds inspection film 91 from the pre-cleaning roll by rotationally driving the post-inspection roll. As illustrated in Figs. 2 and 7A, the roll around which inspection film 91 is wound is disposed in the front-side region of housing 13 and at the center in the up-down direction. Mark board 93 is a region where the discharge inspection of first discharge head 52 and second discharge head 62 is performed, and reference mark 62 is formed according to the nozzle pitch of first discharge head 52 and second discharge head 62. Mark board 93 is a plate-shaped body on which a reference mark is formed. Mark board 93 may be formed of, for example, a transparent member such as a glass plate or a resin plate. The reference mark is a mark serving as a reference for the position and amount of the fluid discharged from first nozzle 53 of first discharge head 52 and second nozzle 63 of second discharge head 62. The shape of the reference mark may be any of a circle, a rectangle, a polygon, a star, and the like, but is more preferably a circle from the viewpoint of grasping the center position and calculating the area. Control device 40 determines whether a fluid discharge state of a nozzle is normal based on a positional relationship between the fluid discharge position and this reference mark, as well as its size. In addition, control device 40 may use inspection unit 90 to determine whether an application state of a liquid material by application section 102 of dispenser unit 100 is normal.

Planarizing unit 94 is a unit that planarizes the fluid discharged onto pallet 47 and/or the fabricated object. As illustrated in Fig. 1, planarizing unit 94 is disposed behind first gantry 16 and at the center in the X axis direction. Planarizing unit 94 includes planarizing member 95 and member cleaning section 96. Planarizing member 95 is a member that comes into contact with and planarizes the fabricated object. Planarizing member 95 may be a planarizing roller that rotates by relative movement with respect to the fabricated object, or may be a flat plate-shaped planarizing blade. When pallet 47 moves along the Y axis, planarizing unit 94 performs planarization by bringing planarizing member 95 into contact with the fabricated object on pallet 47. In this case, moving unit 44 adjusts the height of pallet 47 according to the height of the fabricated object. Planarizing unit 94 may move planarizing member 95 to perform planarization. Member cleaning section 96 removes an object attached to planarizing member 95. For example, when planarizing member 95 is a planarizing roller, member cleaning section 96 may be a cleaning blade that comes into contact with a roller surface. In addition, member cleaning section 96 may be the same member as cleaning members 75 and 88.

Dispenser unit 100 is a unit that supplies a liquid material to the fabricated object on pallet 47. As illustrated in Figs. 2 and 3, dispenser unit 100 is disposed in the central region of housing 13 in the Y axis direction. Dispenser unit 100 is disposed on a conveyance path for carrying pallet 47 into and out of mounting device 12, and is configured to execute an application amount detection process, a carry-in/out process of pallet 47, an imaging process, a height measurement process, and the like in addition to an application process by a dispenser. As illustrated in Figs. 6 and 14, dispenser unit 100 includes application moving section 101, application section 102, application amount detection section 109, height measurement section 112, imaging section 113, and mounting transfer section 114. Application moving section 101 includes a slider that is guided by a guide rail disposed on second gantry 17 and moves along the X axis direction, and a motor that drives the slider. Application head 103 is mounted on the slider, and application head 103 moves along the X axis direction as the slider moves. As illustrated in Fig. 1, application moving section 101 moves application head 103 between the working position, which is on the top of pallet 47 located in the central region of housing 13 along the X axis, or a working position near movement opening 128, and a standby position located on the side surface side opposite to mounting device 12 side.

Application section 102 is a unit in dispenser unit 100 that executes a process of applying a liquid material. Application section 102 includes application head 103, first application section 104, second application section 107, and third application section 108. Each application section includes syringe 105, pressure applying section 106, and an up-down movement section. Application head 103 is a structure that holds each application section and moves in the X axis direction. Application head 103 has no wall portion on a ceiling surface, and is configured to allow airflow to pass through in the up-down direction. As illustrated in Figs. 5 and 7D, syringe 105 is a columnar member that stores a liquid material, and discharges the liquid material from a tip at the bottom when a pressure is applied from above. Examples of the liquid material include multiple types of resins having different viscosities and conductivity, such as a resin in which a conductive material having conductivity is dispersed and a resin having insulating properties. Pressure applying section 106 is supplied with positive pressure or negative pressure from a pressure supply section (not illustrated) and applies a pressure to syringe 105. Syringe 105 is pressed by pressure applying section 106 to discharge the liquid material. The up-down movement section is a linear drive section that moves syringe 105 up and down. Syringe 105 is moved downward by the up-down movement section and discharges the liquid material to an object at a position closer to the object. Second application section 107 and third application section 108 are the same as first application section 104 except that the type of the liquid material is different, and detailed description thereof will be omitted.

Application amount detection section 109 detects the amount of the liquid material discharged from application section 102. Application amount detection section 109 is disposed in the central region of housing 13 and on the side surface side opposite to the one side surface adjacent to mounting device 12, and detects the application amount of the liquid material. Application amount detection section 109 is disposed on a bottom surface of fabricating module 15 below the standby position of application head 103. Application amount detection section 109 includes receiving member 110 and measurement section 111. As illustrated in Fig. 7D, receiving member 110 is a removable dish-shaped member and stores fluid. Measurement section 111 is a device that measures the weight of the liquid material stored in receiving member 110. Application amount detection section 109 applies a freely-selected pressure to syringe 105 and measures the amount of the liquid material discharged from syringe 105 per unit time. Using this measured value, control device 40 controls the discharge amount of the liquid material to an appropriate value.

Height measurement section 112 is configured as a sensor that moves a contact terminal at a tip downward and that obtains, based on a position where the contact terminal comes into contact with an object, the height of the object that has come into contact with the contact terminal. Height measurement section 112 is used when measuring the height of pallet 47, the height of the fabricated object on pallet 47, the height of mark board 93, and the like. Imaging section 113 is a camera that captures an image of a downward region. Imaging section 113 captures images of, for example, an edge portion of pallet 47 to be transferred, the fabricated object on pallet 47, mark board 93 of inspection unit 90, and the like. Mounting transfer section 114 is used when a process of carrying pallet 47 out through movement opening 128 and carrying pallet 47 in through movement opening 128 is executed. Mounting transfer section 114 has a rod structure that is extendable downward, and moves pallet 47 by bringing a tip portion of the rod structure into contact with an edge portion of pallet 47 and pushing pallet 47 out, or by hooking the tip portion to the edge portion and pulling pallet 47 in. Mounting transfer section 114 can be substituted by height measurement section 112.

First curing unit 115 is a unit that executes a predetermined process on pallet 47 or the fabricated object that has been cured on pallet 47 onto which fluid is discharged from first discharge head 52, and then cures the fluid. First curing unit 115 is disposed in the rear-side region of housing 13. First curing unit 115 may cure fluid discharged onto the object by irradiating the fluid with light having a predetermined wavelength. When first discharge head 52 discharges a liquid ultraviolet curable resin, first curing unit 115 is a unit that emits ultraviolet rays. First curing unit 115 includes, for example, ultraviolet ray irradiation section 116. In addition, when first discharge head 52 discharges fluid that is cured by drying and firing, first curing unit 115 may be a unit that performs drying and firing. Each time one layer of the fluid is formed on pallet 47 by first discharge head 52, first curing unit 115 cures the fluid by causing pallet 47 to be moved downward.

Second curing unit 117 is a unit that executes a predetermined process on pallet 47 or the fabricated object that has been cured on pallet 47 onto which fluid is discharged from second discharge head 62, and then cures the fluid. Second curing unit 117 is disposed in the rear-side region of housing 13. Second curing unit 117 may cure fluid discharged onto the object by irradiating the fluid with light having a predetermined wavelength. In addition, when second discharge head 62 discharges fluid that is cured by drying and firing, second curing unit 117 may be a unit that performs drying and firing. Second curing unit 117 may be a unit that emits infrared rays. Second curing unit 117 includes, for example, infrared ray irradiation section 118. Each time one layer of the fluid is formed on pallet 47 by second discharge head 62, second curing unit 117 cures the fluid by causing pallet 47 to be moved downward.

Heating unit 120 is a unit that heats the fabricated object on pallet 47, the liquid material supplied onto pallet 47 or the fabricated object, and the like. Heating unit 120 is disposed in the rear-side region of the housing and on the side surface side opposite to one side surface adjacent to mounting device 12, here, on the right side. Heating unit 120 is disposed on the side surface side away from a movement lane of moving unit 44, and pallet 47 is moved to a position below heating unit 120 by heating transfer section 124. Heating transfer section 124 may have the same mechanism as mounting transfer section 114. Heating unit 120 may heat the fabricated object in a pressed state. As illustrated in Figs. 7E and 14, heating unit 120 includes heating section 121, pressurizing section 122, and pressing-and-heating member 123. Heating section 121 is a heater that heats pressing-and-heating member 123. Pressurizing section 122 moves pallet 47 toward pressing-and-heating member 123 to pressurize the fabricated object. Pressing-and-heating member 123 is a member that comes into contact with and heats and pressurizes the fabricated object. Pressing-and-heating member 123 includes a metal support plate and a rubber plate that is attached to the support plate and that comes into contact with the fabricated object. In pressing-and-heating member 123, a film for suppressing deformation deviation during pressing may be disposed between the rubber plate and the fabricated object. Since pressing-and-heating member 123 may be heated and deformed, pressing-and-heating member 123 is exchanged by the worker every time a fabricated object is manufactured.

Opening/closing unit 125 is a unit that closes and opens movement opening 128. Opening/closing unit 125 is disposed on one side surface side adjacent to mounting device 12. Here, opening/closing unit 125 is disposed in the central region of housing 13 in the Y axis and on the left side. Opening/closing unit 125 is fixed to a conveyor unit that moves pallet 47 to mounting device 12. Therefore, third sliding door 134 (see Fig. 8) that covers the side surface of housing 13 where movement opening 128 is formed is slidable, and removable door 134B (see Fig. 9) is alternatively removable. As illustrated in Figs. 11D, 11E, and 14, opening/closing unit 125 includes shutter section 126 and opening/closing drive section 127. Shutter section 126 blocks light having a predetermined wavelength emitted from first curing unit 115 or second curing unit 117 when closed. When shutter section 126 is closed, release of air from movement opening 128 is also suppressed, and thus heat dissipation to the outside of housing 13 is also reduced. Opening/closing drive section 127 is a linear drive section that moves shutter section 126 between a closed position where movement opening 128 is closed and an open position where movement opening 128 is opened. Opening/closing drive section 127 may be an air cylinder.

Opening and closing door 130 refers to a door group that is opened and closed when maintenance is executed for each unit described above. Opening and closing door 130 is disposed, for example, on at least the front surface of fabricating module 15 and the side surface opposite to one side surface adjacent to mounting device 12 in housing 13. Opening and closing door 130 includes, for example, upper maintenance door 131, first sliding door 132, second sliding door 133, third sliding door 134, cleaning section maintenance door 135, tank maintenance door 136, and heating section maintenance door 137. Upper maintenance door 131 is a large cover member disposed in the front-side region and the upper portion of housing 13. As illustrated in Fig. 7A, upper maintenance door 131 pivots upward about a support shaft along the X axis to open the front upper portion of fabricating module 15. Upper maintenance door 131 functions as a discharge section maintenance door that is opened and closed when maintenance is performed for first discharge unit 50 and second discharge unit 60, a maintenance section maintenance door that is opened and closed when maintenance is performed for first maintenance unit 70 and second maintenance unit 80, and an inspection section maintenance door that is opened and closed when maintenance is performed for inspection unit 90 and attachment and detachment of inspection film 91. In addition, upper maintenance door 131 also functions as a moving section maintenance door that is opened and closed when maintenance is performed for moving unit 44. When upper maintenance door 131 pivots to the open position, the worker can execute maintenance work of each unit such as moving unit 44, first discharge unit 50, second discharge unit 60, first maintenance unit 70, and second maintenance unit 80, and can execute exchange work of consumables such as cleaning member 75 and inspection film 91.

First sliding door 132 and second sliding door 133 are disposed from the front upper portion to the center portion of housing 13 on the side surface side not adjacent to mounting device 12. First sliding door 132 and second sliding door 133 are sliding doors, either of which can be opened. First sliding door 132 is disposed in a front-side region of the side surface of fabricating module 15. As illustrated in Fig. 7B, first sliding door 132 slides rearward to open a front-right portion of fabricating module 15. First sliding door 132 functions as a discharge section maintenance door that is opened and closed when maintenance is performed for second discharge unit 60, a maintenance section maintenance door that is opened and closed when maintenance is performed for second maintenance unit 80, and a seal section maintenance door that is opened and closed when maintenance is performed for seal member 85. When first sliding door 132 is opened, the worker can execute maintenance work of each unit such as second discharge unit 60 and second maintenance unit 80, and can execute exchange work of consumables such as cleaning member 75 and seal member 85. Second sliding door 133 is disposed at the center of the side surface of fabricating module 15 in the front-rear direction. As illustrated in Fig. 7D, second sliding door 133 slides forward to open a right-center portion of fabricating module 15. Second sliding door 133 is an application section maintenance door that is opened and closed when maintenance is performed for dispenser unit 100 or when maintenance is performed for syringe 105 and application amount detection section 109. In addition, second sliding door 133 may also function as a planarizing section maintenance door that is opened and closed when maintenance is performed for planarizing unit 94. When second sliding door 133 is opened, the worker can execute maintenance work of dispenser unit 100 and planarizing unit 94, and can execute exchange work of syringe 105, receiving member 110, and the like.

As illustrated in Fig. 7G, cleaning section maintenance doors 135 are disposed on the left and right sides of the central portion in the up-down direction of the front surface of housing 13. Cleaning section maintenance door 135 is an opening and closing door that is opened and closed when attaching and detaching cleaning member 75 after cleaning. An opening end of cleaning section maintenance door 135 is pivoted by a hinge fixed to a side surface toward the side surface side to open right and left portions of a middle front region of fabricating module 15. The pivot direction of cleaning section maintenance door 135 may be a freely-selected direction. When cleaning section maintenance door 135 is opened, the worker can execute exchange work of consumables such as cleaning member 75 after cleaning. As illustrated in Fig. 7F, tank maintenance door 136 is disposed in a lower portion of the front surface of housing 13. Tank maintenance door 136 is an opening and closing door that is opened and closed when storage members are attached and detached such as first supply tank 56, first recovery tank 57, second supply tank 66, and second recovery tank 67. An opening end of tank maintenance door 136 is pivoted downward by a hinge fixed to a lower side to open a lower front portion of fabricating module 15. The pivot direction of tank maintenance door 136 may be any direction. When tank maintenance door 136 is opened, the worker can execute exchange work of any one or more of the storage members. Heating section maintenance door 137 is disposed in the rear-side region of housing 13 on the side surface side not adjacent to mounting device 12. As illustrated in Fig. 7E, an opening end of heating section maintenance door 137 is pivoted forward by a hinge fixed to the center to open a rear-right portion of fabricating module 15. The pivot direction of heating section maintenance door 137 may be any direction, and the opening end of the door may be pivoted rearward by a hinge fixed to the rear side of fabricating module 15 to open the rear-right portion of fabricating module 15. Heating section maintenance door 137 is an opening and closing door that is opened and closed when maintenance is performed for heating unit 120 and attachment and detachment of pressing-and-heating member 123. When heating section maintenance door 137 is opened, the worker can execute maintenance work of heating unit 120 and execute exchange work of pressing-and-heating member 123 and the like.

As illustrated in Fig. 8, fabricating module 15 of housing 13 includes third sliding door 134 that is slidable so that at least a part of the side surface of housing 13 on which mounting device 12 is disposed opens to the outside when mounting module 36 is slid with respect to mounting base 35. When the opening is opened by third sliding door 134, the worker can easily execute maintenance work of the units located behind fabricating module 15 and on mounting device 12 side. In Fig. 8, third sliding door 134 is exemplified as a structure that can slide forward with respect to housing 13; however, the configuration is not particularly limited to this, and third sliding door 134 may be a sliding door that can slide rearward or upward with respect to housing 13. Furthermore, instead of third sliding door 134, housing 13 may include removable door 134B that is removable so that at least a part of the side surface on which mounting device 12 is disposed opens to the outside, as illustrated in Fig. 9. In housing 13 as well, the worker can easily execute maintenance work of the units located behind fabricating module 15 and on mounting device 12 side.

As illustrated in Fig. 1 and Figs. 8 to 10, housing 13 has one or more access windows 19 formed between fabricating base 14 and fabricating module 15, access windows 19 allowing access to the inside of fabricating base 14 when mounting module 36 is slid to the open position. Access window 19 is formed on an upper surface of a rear region of fabricating base 14 and a lower surface of a rear region of fabricating module 15. In the illustrated example, housing 13 has four access windows 19, but the number of the windows is not particularly limited, and any number of windows equal to or greater than one can be used as long as the strength of housing 13 can be ensured. The worker can easily execute maintenance work on the units accommodated in the rear region of fabricating base 14 through access window 19.

As illustrated in Figs. 12C and 12E, multiple members are disposed inside fabricating base 14 such that the heights tend to be lower as the multiple members are closer to the side surface accessible from the outside. Examples of the multiple members include a servo amplifier, a PC, a UPS, a breaker, a safety circuit device, a PCL, a DC power supply, a light source power supply, a load cell amplifier, a step motor controller, an infrared heater controller, a UV lamp controller, a temperature controller, and a dispenser controller. Among these, in fabricating base 14, a breaker having a relatively low height and requiring maintenance work may be disposed further forward, and a relatively large controller among various controllers may be disposed further backward. In addition, as illustrated in Fig. 12C, multiple members are disposed in the front-side region and the central region of fabricating base 14 in the front-rear direction of fabricating base 14 such that the heights tend to be lower as the multiple members are closer to the side surface accessible from the outside. The expression "the heights tend to be lower" is intended to allow the presence of a region in which the height is constant or a range in which the height increases as the position changes from the side farther from the side surface toward the side closer to the side surface, and is to be understood as meaning that, as a whole, the side closer to the side surface is lower in height. In fabricating base 14, when a cover on the side surface not adjacent to mounting device 12 is opened, the worker can easily execute maintenance work from the front toward the rear.

In addition, as illustrated in Fig. 12D, multiple cable racks 160 are disposed inside fabricating base 14, and the disposition heights tend to be lower as multiple cable racks 160 are farther from the side surface accessible from the outside. Cable rack 160 has a vertical support portion and a horizontal placement portion, and has an L-shaped cross section. In cable rack 160, the support portion is fixed to an upper portion of fabricating base 14, and the placement portion is open to the side surface side. Since cable rack 160 fixed farther to the rear is lower in height, the worker can more easily install cables on cable rack 160 located in the rear. Fig. 12D illustrates the disposition of cable racks 160 in consideration of access from both sides in a state before mounting device 12 is installed.

Air blowing unit 140 is a unit that blows outside air into housing 13, blows internal air inside housing 13 to the outside, and exhausts heat from inside the device. Air blowing unit 140 includes moving section intake section 141, housing air blowing section 142, first curing exhaust section 147, second curing exhaust section 148, heating section exhaust section 149, base air blowing section 150, base intake section 151, and exhaust port 152. Moving section intake section 141 is a fan that sends outside air into housing 13 from the center of the front surface of housing 13 in which moving unit 44 is disposed. First exhaust section 144 and second exhaust section 146 of housing air blowing section 142 are fans that discharge internal air from the center of the rear surface of housing 13 to the outside of housing 13. Moving section intake section 141, first exhaust section 144, and second exhaust section 146 constitute a moving section air blowing section that cools moving unit 44. When moving section 45 of moving unit 44 is a linear motor that generates a relatively large amount of heat, the moving section air blowing section can sufficiently manage the heat generation of moving section 45.

As illustrated in Figs. 1 and 13, housing air blowing section 142 sends outside air into housing 13 from above first discharge unit 50 and second discharge unit 60 in housing 13, and discharges internal air from the rear side of housing 13. Housing air blowing section 142 includes first intake section 143, first exhaust section 144, second intake section 145, and second exhaust section 146. First intake section 143 and first exhaust section 144 are units that exhaust heat on first discharge unit 50 side. Second intake section 145 and second exhaust section 146 are units that exhaust heat on second discharge unit 60 side. As illustrated in Fig. 5, first intake section 143 is a fan that is disposed on the upper left side of first gantry 16 and second gantry 17 and that sends outside air into fabricating module 15. First exhaust section 144 is a fan that is disposed on the center left side in the up-down direction of the rear surface of housing 13 and that sends internal air of fabricating module 15 to the outside. Second intake section 145 is a fan that is disposed on the upper right side of first gantry 16 and second gantry 17 and that sends outside air into fabricating module 15. Second exhaust section 146 is a fan that is disposed on the center right side in the up-down direction of the rear surface of housing 13 and that sends internal air of fabricating module 15 to the outside. As illustrated in Fig. 5, housing air blowing section 142 is disposed at a position for sending outside air to a region between the standby position and the working position of each of first discharge head 52 and second discharge head 62. First discharge head 52, second discharge head 62, and application head 103 do not have a structure that is blocked by a wall portion in the horizontal direction, so that air blown from above passes directly downward. In addition, housing air blowing section 142 continues to blow air even when first discharge head 52 or second discharge head 62 is at the standby position or the working position and even when first discharge head 52 or second discharge head 62 moves between the positions. Then, as illustrated in Fig. 13, housing air blowing section 142 takes in outside air from the front-upper side of housing 13, causes the air to pass through the respective units, and discharges the air together with heat from the rear side of housing 13 where units that generate a large amount of heat are disposed. Air blowing unit 140 can more appropriately exhaust heat from inside housing 13, thereby enabling more appropriate heat management of three-dimensional printer 11.

First curing exhaust section 147 is configured as a first air blowing section that discharges internal air from above first curing unit 115 to the rear side of housing 13. Second curing exhaust section 148 is configured as a second air blowing section that discharges internal air from above second curing unit 117 to the rear side of housing 13. Heating section exhaust section 149 is configured as a heating section air blowing section that discharges internal air from above heating unit 120 to the right side surface on the rear side of housing 13. First curing exhaust section 147, second curing exhaust section 148, and heating section exhaust section 149 can more appropriately perform heat management for each individual unit having a larger heat generation amount.

Base air blowing section 150 is an air blowing device disposed on fabricating base 14, and includes a base air blowing section that sends outside air into fabricating base 14 from the rear side of the fabricating base and that discharges internal air from the front lower surface of fabricating base 14. Base air blowing section 150 includes base intake sections 151 and exhaust ports 152. Base intake sections 151 are fans that are disposed on the left and right sides of the lower portion of the rear surface of housing 13 and that send outside air into fabricating base 14. Exhaust ports 152 are openings that are disposed on the left and right sides of the lower surface of the front-side region of housing 13 and through which the air sent by base intake section 151 is discharged. Base air blowing section 150 blows air from the rear side of housing 13 to the front lower surface, thereby enabling more appropriate heat management of the units disposed inside fabricating base 14. In addition, air blowing unit 140 includes fabricating module 15 that blows air from the front upper side to the rear side of housing 13 and fabricating base 14 that blows air from the rear side to the front lower surface of housing 13, and by adopting different air blowing directions, it is possible to more appropriately take measures against heat of three-dimensional printer 11.

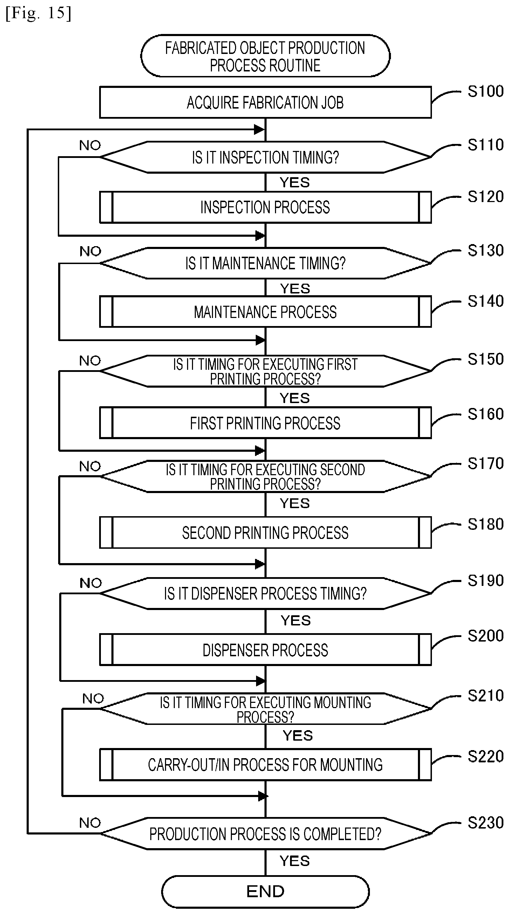

Next, a three-dimensional fabricating process of three-dimensional printer 11 configured as described above will be described. Fig. 15 is a flowchart illustrating an example of a fabricated object production process routine executed by control section 41 of control device 40. The routine is stored in storage section 42 and is executed by control device 40 after an execution command of a production process is input by the worker. When this routine is started, control section 41 of control device 40 first reads and acquires fabrication job 43 from storage section 42 (S100), and determines whether it is an inspection timing of first discharge unit 50 and second discharge unit 60 (S110). The inspection timing may be, for example, when new production is started, when a predetermined number of fabricated objects such as five or ten have been produced, or when a predetermined time such as 30 minutes or one hour has elapsed. When it is currently the inspection timing, control section 41 executes an inspection process for first discharge head 52 and/or second discharge head 62 (S120). In this process, control section 41 executes the inspection process using inspection unit 90. Specifically, control section 41 moves mark board 93 to a position below first discharge head 52 or second discharge head 62 to discharge fluid onto mark board 93, captures an image of mark board 93 with imaging section 113, and determines a discharge state of the fluid.

After S120, or when it is not the inspection timing in S110, control section 41 determines whether it is a maintenance timing (S130). The maintenance timing may be, for example, when a defective nozzle is found during the inspection process, when a predetermined number of fabricated objects such as five or ten have been produced, or when a predetermined time such as 30 minutes or one hour has elapsed. When it is currently the maintenance timing, control section 41 executes a maintenance process for first discharge head 52 and/or second discharge head 62 (S140). In this process, control section 41 executes a maintenance process for first discharge unit 50 and second discharge unit 60 using first maintenance unit 70 and second maintenance unit 80. Specifically, control section 41 executes a flushing process of moving first discharge head 52 to a position below first discharge receiving section 73 or moving second discharge head 62 to a position below second discharge receiving section 86 to forcibly discharge the fluid. Alternatively, control section 41 moves first cleaning section 74 to a position below first discharge head 52 and performs the cleaning process on the nozzle plate with cleaning member 75. Alternatively, control section 41 moves second cleaning section 87 to a position below second discharge head 62 and performs the cleaning process on the nozzle plate with cleaning member 88.

After S140, or when it is not the maintenance timing in S130, control section 41 determines, based on fabrication job 43, whether it is a timing for executing first printing by first discharge unit 50 (S150). When it is the timing for executing the first printing, control section 41 executes a first printing process (S160). In the first printing process, control section 41 causes first discharge unit 50 to discharge fluid onto pallet 47, causes planarizing unit 94 to perform a planarizing process, and causes first curing unit 115 to cure the discharged fluid. After S160 or when it is not the timing for executing the first printing in S150, control section 41 determines, based on fabrication job 43, whether it is a timing for executing second printing (S170). When it is the timing for executing the second printing, control section 41 executes a second printing process (S180). In the second printing process, control section 41 causes second discharge unit 60 to discharge fluid onto pallet 47 and/or the fabricated object, and causes second curing unit 117 to cure the discharged fluid.

After S180, or when it is not the timing for executing the second printing in S170, control section 41 determines, based on fabrication job 43, whether it is a dispenser process timing (S190). When it is the dispenser process timing, control section 41 causes dispenser unit 100 to execute a dispenser process (S200). In this process, for example, control section 41 executes a process of applying a conductive paste onto the fabricated object from application section 102 or filling a groove portion or the like of the fabricated object with a resin from application section 102, and applies pressure and heat with heating unit 120 to cure the liquid material. Control section 41 causes application amount detection section 109 to detect the application amount of application section 102 prior to the dispenser process, and executes the dispenser process based on the application amount. After S200, or when it is not the dispenser process timing in S190, control section 41 determines, based on fabrication job 43, whether it is a mounting process timing (S210). When it is the mounting process timing, control section 41 executes a process of carrying pallet 47 in and out of mounting device 12 (S220). In this process, control section 41 executes a process of carrying pallet 47 into mounting device 12 by mounting transfer section 114 and a process of carrying pallet 47 on which the fabricated object with the components disposed thereon is placed out of mounting device 12. When pallet 47 is carried in, control section 22 of mounting device 12 causes mounting section 30 to execute a process of placing the component on the fabricated object based on mounting information 24.

After S220 or when it is not the timing for executing the mounting process in S210, control section 41 determines whether the production process is completed (S230). When the production process is not completed, control section 41 executes the processes of S110 and subsequent steps. To the contrary, when the production process is completed in S230, this routine ends. During the production process, air blowing unit 140 blows air to each unit inside fabricating base 14 and each unit inside fabricating module 15, thereby executing heat management. During such a production process or between the production processes, the worker opens and closes opening and closing door 130 to execute maintenance work of each unit.

Here, correspondence relationships between the elements of the present embodiment and the elements of the present disclosure will be clarified. Three-dimensional printer 11 of the present embodiment corresponds to an example of a printing device of the present disclosure, mounting device 12 corresponds to an example of a mounting device, pallet 47 corresponds to an example of an object, movement opening 128 corresponds to an example of a movement opening, housing 13 corresponds to an example of a housing, and opening and closing door 130 corresponds to an example of an opening and closing door.

Three-dimensional printer 11 of the present embodiment described above fabricates a fabricated object having wiring, three-dimensional printer 11 including: housing 13 that accommodates multiple units, the housing having mounting device 12 configured to mount a component on the fabricated object disposed adjacent to a first side surface, in which movement opening 128 through which pallet 47 serving as an object on which the fabricated object is placed is moved between housing 13 and mounting device 12 is formed on the first side surface of housing 13, and opening and closing door 130 for maintaining any of the multiple units is disposed on at least a front surface and a side surface opposite to the first side surface of housing 13. In three-dimensional printer 11, since opening and closing door 130 corresponding to each unit is disposed on the front surface and the side surface different from the surface adjacent to mounting device 12, the worker can easily access a unit serving as a maintenance target, and the efficiency of the maintenance work can be further improved.

In addition, in three-dimensional printer 11, the multiple units include moving unit 44 configured to move an object onto which fluid is to be discharged, first discharge unit 50 disposed in a front-side region of housing 13 and configured to discharge fluid for forming a structure, second discharge unit 60 disposed in the front-side region of housing 13 and configured to discharge fluid for forming the wiring, first curing unit 115 disposed in a rear-side region of housing 13 and configured to cure the fluid for forming the structure discharged onto pallet 47, and second curing unit 117 disposed in the rear-side region of housing 13 and configured to cure the fluid for forming the wiring discharged onto pallet 47. In three-dimensional printer 11, for example, the discharge unit, the curing unit, and the like are easily accessible, which can further improve the efficiency of the maintenance work. Furthermore, in three-dimensional printer 11, the multiple units include first maintenance unit 70 and/or second maintenance unit 80 that performs maintenance for first discharge unit 50 and/or second discharge unit 60, and housing 13 is provided with, as opening and closing door 130, upper maintenance door 131 serving as a discharge section maintenance door and a maintenance section maintenance door provided on the front surface and/or the side surface, upper maintenance door 131 enabling performance of maintenance for first discharge unit 50 and/or second discharge unit 60. In three-dimensional printer 11, upper maintenance door 131 can further improve the efficiency of the maintenance work for the discharge unit and the maintenance unit. Furthermore, maintenance unit of first maintenance unit 70 and second maintenance unit 80 include cleaning members 75 and 88 disposed in the front-side region of housing 13 and configured to clean first discharge unit 50 and/or second discharge unit 60, and cleaning section maintenance door 135 serving as opening and closing door 130 for attaching and detaching cleaning members 75 and 88 is disposed in an upper portion of the front surface of housing 13 and/or a central portion in an up-down direction. In three-dimensional printer 11, cleaning section maintenance door 135 can further improve the efficiency of the maintenance work for cleaning members 75 and 88.

In addition, the maintenance unit includes seal member 85 disposed in the front-side region and on a side surface side of housing 13 and configured to seal second nozzle 63 that discharges the fluid, and first sliding door 132 serving as opening and closing door 130 and enabling performance of maintenance for seal member 85 is disposed in a front-side region of the side surface of housing 13. In three-dimensional printer 11, first sliding door 132 can further improve the efficiency of the maintenance work for seal member 85. Furthermore, in three-dimensional printer 11, the multiple units include inspection unit 90 configured to inspect a discharge state of first discharge unit 50 and/or second discharge unit 60, inspection unit 90 can be disposed in the front-side region of housing 13, inspection film 91 onto which the fluid is discharged can be attached thereto and detached therefrom, and upper maintenance door 131 serving as an inspection section maintenance door for attaching and detaching inspection film 91 is disposed in an upper portion of the front surface of housing 13 and/or a central portion in an up-down direction. In three-dimensional printer 11, upper maintenance door 131 can further improve the efficiency of the maintenance work for inspection film 91. Furthermore, first discharge unit 50 and/or second discharge unit 60 includes first supply tank 56 and second supply tank 66 that are disposed in the front-side region of housing 13 and that are configured to supply the fluid and first recovery tank 57 and second recovery tank 67 configured to store the fluid that is recovered, and tank maintenance door 136 that enables performance of maintenance for the supply tank and/or the recovery tank is disposed in a lower portion of the front surface of housing 13. In three-dimensional printer 11, tank maintenance door 136 can further improve the efficiency of the maintenance work for the supply tank and the recovery tank. In three-dimensional printer 11, the multiple units include dispenser unit 100 disposed in a central region of housing 13 and configured to supply a liquid material to pallet 47, and second sliding door 133 serving as an application section maintenance door and enabling performance of maintenance for dispenser unit 100 and maintenance for syringe 105 and application amount detection section 109 is disposed in housing 13. In three-dimensional printer 11, second sliding door 133 can further improve the efficiency of the maintenance work for dispenser unit 100, syringe 105, and receiving member 110. In addition, in three-dimensional printer 11, the multiple units include heating unit 120 disposed in a rear-side region of housing 13 and configured to heat a liquid material supplied to pallet 47, heating unit 120 includes a pressing-and-heating section disposed in the rear-side region and on a side surface side of housing 13 and configured to relatively press-heat the fabricated object on pallet 47 using pressing-and-heating member 123, and heating section maintenance door 137 serving as opening and closing door 130 and enabling performance of maintenance for pressing-and-heating member 123 is disposed in a rear-side region of the side surface of housing 13. In three-dimensional printer 11, heating section maintenance door 137 can further improve the efficiency of the maintenance work for heating unit 120.

In addition, three-dimensional printer 11 includes operation panel 8 that is rotatable so that a display surface faces the front surface and the side surface of housing 13 on which opening and closing door 130 is disposed. In three-dimensional printer 11, since the display surface is pivotable according to whether the worker performs work at the front side or at the side surface, the worker can efficiently perform tasks, such as checking the display contents of operation panel 48 or inputting operations, regardless of the working position. Furthermore, housing 13 includes fabricating base 14 serving as a pedestal, and fabricating module 15 that is disposed above fabricating base 14 and accommodates the multiple units, mounting device 12 includes mounting base 35 serving as a pedestal, and mounting module 36 that is disposed above mounting base 35, is supported slidably along the side surface of housing 13 with respect to mounting base 35, and accommodates mounting section 30 configured to execute a mounting process, and housing 13 includes sliding door 134 that is slidable so that at least a part of the side surface on which mounting device 12 is disposed opens to the outside when mounting module 36 is slid with respect to mounting base 35. Alternately, housing 13 includes removable door 134B that is removable so that at least a part of the side surface on which mounting device 12 is disposed opens to the outside when mounting module 36 is slid with respect to mounting base 35. In three-dimensional printer 11, since access to the inside of housing 13 is possible from other than opening and closing door 130 on the second side surface by opening sliding door 134 or removable door 134B, the efficiency of the maintenance work for each unit can be further improved.

In addition, housing 13 has one or more access windows 19 formed between fabricating base 14 and fabricating module 15, access windows 19 allowing access to an inside of fabricating base 14 through the opening. In three-dimensional printer 11, since the inside of fabricating base 14 is accessible through access window 19, the efficiency of the maintenance work for the members disposed in fabricating base 14 can be further improved. Furthermore, multiple members are disposed inside fabricating base 14 such that the heights tend to be lower as the multiple members are closer to the side surface accessible from the outside. In three-dimensional printer 11, in fabricating base 14, the members are lower in height as the members are closer to the side surface from which the interior is accessible, so that members located farther to the rear can be accessed, thereby further improving the efficiency of the maintenance work on the members in fabricating base 14. Furthermore, multiple cable racks 160 are disposed inside fabricating base 14 such that the disposition heights tend to be lower as multiple cable racks 160 are farther from the side surface accessible from the outside. In three-dimensional printer 11, in fabricating base 14, cable racks 160 are lower in height as the members are farther from the side surface from which the interior is accessible, so that cable rack 160 located farther to the rear can be accessed, thereby further improving the efficiency of the maintenance work on the cables in fabricating base 14. First curing unit 115 irradiates the fluid discharged onto pallet 47 with light having a predetermined wavelength to cure the fluid, and housing 13 is provided with shutter section 126 configured to close and open movement opening 128 and block the light having the predetermined wavelength when closing movement opening 128. In three-dimensional printer 11, it is possible to prevent leakage of light from movement opening 128, thereby further improving the safety of the worker performing the work. In addition, printing system 10 includes three-dimensional printer 11 described above and mounting device 12 configured to mount a component on the fabricated object. In printing system 10, similarly to three-dimensional printer 11 described above, the worker can easily access a unit serving as a maintenance target, and the efficiency of the maintenance work can be further improved.

Here, the printing device and the printing system of the present disclosure are not limited to those described in the embodiment at all, and hence, it goes without saying that the printing device and the printing method can be carried out in various aspects without departing from the technical scope of the present disclosure.

For example, in the above-described embodiment, the "multiple systems" include moving unit 44, first discharge unit 50, second discharge unit 60, first maintenance unit 70, second maintenance unit 80, inspection unit 90, planarizing unit 94, dispenser unit 100, heating unit 120, opening/closing unit 125, air blowing unit 140, and the like; however, the configuration is not particularly limited to this, and any one or more of these units may be omitted or a unit other than the above-described units may be included. In this case, among opening and closing doors 130, an opening and closing door for the omitted or added unit may be omitted or added. In this three-dimensional printer 11, it is possible to further improve the efficiency of the maintenance work for the unit provided in housing 13.

In the above-described embodiment, operation panel 48 is rotatable to the front surface and the side surface, but this may be omitted. In this three-dimensional printer 11 as well, the efficiency of the maintenance work of each unit can be further improved.

In the above-described embodiment, housing 13 includes third sliding door 134 and removable door 134 B on the side surface on which mounting module 36 slides; however, the configuration is not particularly limited to this, and the opening and closing door of the opening may be omitted. In addition, housing 13 is described as having one or more access windows 19; however, the configuration is not particularly limited to this, and access windows 19 may be omitted. Even in this case, three-dimensional printer 11 can further improve the efficiency of the maintenance work of the corresponding unit by opening and closing door 130.

In the above-described embodiment, the members accommodated in fabricating base 14 of housing 13 are disposed such that the heights tend to be lower as the members are closer to the side surface accessible from the outside; however, the configuration is not particularly limited to this, and the height may be freely selected. In addition, in the above-described embodiment, cable racks 160 are disposed in fabricating base 14 such that the disposition heights tend to be lower as cable racks 160 are farther from the side surface accessible from the outside; however, the configuration is not particularly limited to this. The height may be freely selected. Further, housing 13 includes shutter section 126; however, the configuration is not particularly limited to this, and shutter section 126 may be omitted.

In the above-described embodiment, printing system 10 has been described; however, the configuration is not particularly limited to this, and printing system 10 may include only three-dimensional printer 11 and mounting device 12. In addition, in the above-described embodiment, printing system 10 and three-dimensional printer 11 are provided, but a method for controlling a printing device or a program thereof may be provided.

The present description also discloses a technical idea in which "the printing device according to Claim 3" in Claim 5 as originally filed is changed to "the printing device according to Claim 3 or 4", a technical idea in which "the printing device according to Claim 2" in Claim 6 as originally filed is changed to "the printing device according to any one of Claims 2 to 5", a technical idea in which "the printing device according to Claim 2 or 3" in Claim 7 as originally filed is changed to "the printing device according to any one of Claims 2 to 6", a technical idea in which "the printing device according to Claim 1 or 2" in Claim 8 as originally filed is changed to "the printing device according to any one of Claims 1 to 7", a technical idea in which "the printing device according to Claim 1 or 2" in Claim 10 as originally filed is changed to "the printing device according to any one of Claims 1 to 9", a technical idea in which "the printing device according to Claim 1 or 2" in Claim 11 as originally filed is changed to "the printing device according to any one of Claims 1 to 10", a technical idea in which "the printing device according to Claim 1 or 2" in Claim 12 as originally filed is changed to "the printing device according to any one of Claims 1 to 11", a technical idea in which "the printing device according to Claim 1 or 2" in Claim 14 as originally filed is changed to "the printing device according to any one of Claims 1 to 13", a technical idea in which "the printing device according to Claim 1 or 2" in Claim 15 as originally filed is changed to "the printing device according to any one of Claims 1 to 14", a technical idea in which "the printing device according to Claim 2" in Claim 16 as originally filed is changed to "the printing device according to any one of Claims 2 to 15", and a technical idea in which "the printing device according to Claim 1 or 2" in Claim 17 as originally filed is changed to "the printing device according to any one of Claims 1 to 16".

### Industrial Applicability

The present disclosure can be used in the technical field of a device that discharges fluid and manufactures a fabricated object.

### Reference Signs List

10: Printing system, 11: Three-dimensional printer, 12: Mounting device, 13: Housing, 14: Fabricating base, 15: Fabricating module, 16: First gantry, 17: Second gantry, 18: Third gantry, 19: Access window, 20: Housing, 21: Control device, 22: Control section, 23: Storage section, 24: Mounting information, 25: Conveyance processing section, 26: Imaging section, 27: Component supply section, 28: Feeder, 29: Operation panel, 30: Mounting section, 31: Moving section, 32: Mounting head, 33: Collection member, 34: Communication section, 35: Mounting base, 36: Mounting module, 40: Control device, 41: Control section, 42: Storage section, 43: Fabrication job, 44: Moving unit, 45: Moving section, 46: Lifting and lowering section, 47: Pallet, 48: Operation panel, 49: Communication section, 50: First discharge unit, 51: First head moving section, 52: First discharge head, 53: First nozzle, 53a: Discharge drive section, 53b: Liquid valve, 54: First fluid processing section, 55: First liquid feeding section, 56: First supply tank, 57: First recovery tank, 58: Pipe, 59: Head tank, 60: Second discharge unit, 61: Second head moving section, 62: Second discharge head, 63: Second nozzle, 64: Second fluid processing section, 65: Second liquid feeding section, 66: Second supply tank, 67: Second recovery tank, 68: Pipe, 70: First maintenance unit, 71: First maintenance moving section, 72: First seal section, 73: First discharge receiving section, 74: First cleaning section, 75: Cleaning member, 76: Feeding section, 80: Second maintenance unit, 81: Second maintenance moving section, 82: Second seal section, 83: Dry seal section, 84: Wet seal section, 85: Seal member, 86: Second discharge receiving section, 87: Second cleaning section, 88: Cleaning member, 89: Feeding section, 90: Inspection unit, 91: Inspection film, 92: Feeding section, 93: Mark board, 94: Planarizing unit, 95: Planarizing member, 96: Member cleaning section, 100: Dispenser unit, 101: Application moving section, 102: Application section, 103: Application head, 104: First application section, 105: Syringe, 106: Pressure applying section, 107: Second application section, 108: Third application section, 109: Application amount detection section, 110: Receiving member, 111: Measurement section, 112: Height measurement section, 113: Imaging section, 114: Mounting transfer section, 115: First curing unit, 116: Ultraviolet ray irradiation section, 117: Second curing unit, 118: Infrared ray irradiation section, 120: Heating unit, 121: Heating section, 122: Pressurizing section, 123: Pressing-and-heating member, 124: Heating transfer section, 125: Opening/closing unit, 126: Shutter section, 127: Opening/closing drive section, 128: Movement opening, 130: Opening and closing door, 131: Upper maintenance door, 132: First sliding door, 133: Second sliding door, 134: Third sliding door, 134B: Removable door, 135: Cleaning section maintenance door, 136: Tank maintenance door, 137: Heating section maintenance door, 140: Air blowing unit, 141: Moving section intake section, 142: Housing air blowing section, 143: First intake section, 144: First exhaust section, 145: Second intake section, 146: Second exhaust section, 147: First curing exhaust section, 148: Second curing exhaust section, 149: Heating section exhaust section, 150: Base air blowing section, 151: Base intake section, 152: Exhaust port, 160: Cable rack

## Claims

1. A printing device for fabricating a fabricated object having wiring, the printing device comprising:
a housing that accommodates multiple units, the housing having a mounting device configured to mount a component on the fabricated object disposed adjacent to a first side surface of the housing,
wherein a movement opening through which an object on which the fabricated object is placed is moved between the housing and the mounting device is formed on the first side surface of the housing, and
an opening and closing door configured to maintain any of the multiple units is disposed on at least a front surface and a side surface opposite to the first side surface of the housing.

2. The printing device according to Claim 1,
wherein the multiple units include
a moving unit configured to move the object onto which fluid is to be discharged,
a first discharge unit disposed in a front-side region of the housing and configured to discharge fluid for forming a structure,
a second discharge unit disposed in the front-side region of the housing and configured to discharge fluid for forming the wiring,
a first curing unit disposed in a rear-side region of the housing and configured to cure the fluid for forming the structure discharged onto the object, and
a second curing unit disposed in the rear-side region of the housing and configured to cure the fluid for forming the wiring discharged onto the object.

3. The printing device according to Claim 2,
wherein the multiple units include a maintenance unit configured to perform maintenance for the first discharge unit and/or the second discharge unit, and
the housing is provided with, as the opening and closing door, at least one of: a discharge section maintenance door provided on the front surface and/or the side surface, the discharge section maintenance door being configured to perform maintenance for the first discharge unit and/or the second discharge unit; and a maintenance section maintenance door provided on the front surface and/or the side surface, the maintenance section maintenance door being configured to perform maintenance for the maintenance unit.

4. The printing device according to Claim 3,
wherein the maintenance unit includes a cleaning member disposed in the front-side region of the housing and configured to clean the first discharge unit and/or the second discharge unit, and
a cleaning section maintenance door serving as the opening and closing door is disposed in an upper portion of the front surface of the housing and/or a central portion in an up-down direction, the cleaning section maintenance door being configured to enable attachment and detachment of the cleaning member.

5. The printing device according to Claim 3,
wherein the maintenance unit includes a seal member disposed in the front-side region and on a side surface side of the housing and configured to seal a discharge nozzle configured to discharge the fluid, and
a seal section maintenance door serving as the opening and closing door is disposed in a front-side region of the side surface of the housing, the seal section maintenance door being configured to enable performance of maintenance for the seal member.

6. The printing device according to Claim 2,
wherein the multiple units include an inspection unit configured to inspect a discharge state of the first discharge unit and/or the second discharge unit,
the inspection unit can be disposed in the front-side region of the housing and is attachable to and detachable from an inspection film onto which the fluid is discharged, and
an inspection section maintenance door serving as the opening and closing door is disposed in an upper portion of the front surface of the housing and/or a central portion in an up-down direction, the inspection section maintenance door being configured to enable attachment and detachment of the inspection film.

7. The printing device according to Claim 2 or 3,
wherein the first discharge unit and/or the second discharge unit is disposed in the front-side region of the housing and includes a supply tank configured to supply the fluid and a recovery tank configured to store the fluid that is recovered, and
a tank maintenance door serving as the opening and closing door is disposed in a lower portion of the front surface of the housing, the tank maintenance door being configured to enable performance of maintenance for the supply tank and/or the recovery tank.

8. The printing device according to Claim 1 or 2,
wherein the multiple units include a dispenser unit disposed in a central region of the housing and configured to supply a liquid material to the object, and
an application section maintenance door serving as the opening and closing door is disposed in the housing, the application section maintenance door being configured to enable performance of maintenance for the dispenser unit.

9. The printing device according to Claim 8,
wherein the dispenser unit includes a syringe configured to supply the liquid material to the dispenser unit, and a detection section disposed in the central region and on a side surface side of the housing and configured to detect an application amount of the liquid material, and
an application section maintenance door serving as the opening and closing door is disposed at a center of the side surface of the housing in a front-rear direction, the application section maintenance door being configured to enable performance of maintenance for the syringe and the detection section.

10. The printing device according to Claim 1 or 2,
wherein the multiple units include a heating unit disposed in a rear-side region of the housing and configured to heat a liquid material supplied to the object,
the heating unit includes a pressing-and-heating section disposed in the rear-side region and on a side surface side of the housing and configured to relatively press-heat the fabricated object using a pressing-and-heating member, and
a heating section maintenance door serving as the opening and closing door is disposed in a rear-side region of the side surface of the housing, the heating section maintenance door being configured to enable performance of maintenance for the pressing-and-heating member.

11. The printing device according to Claim 1 or 2, further comprising:
an operation panel that is rotatable so that a display surface faces the front surface and the side surface of the housing on which the opening and closing door is disposed.

12. The printing device according to Claim 1 or 2,
wherein the housing includes a fabricating base serving as a pedestal, and a fabricating module that is disposed above the fabricating base and accommodates the multiple units,
the mounting device includes a mounting base serving as a pedestal, and a mounting module that is disposed above the mounting base, is supported slidably along the side surface of the housing with respect to the mounting base, and accommodates a mounting section configured to execute a mounting process, and
the housing includes a removable door that is removable so that at least a part of the side surface on which the mounting device is disposed has an opening to an outside when the mounting module is slid with respect to the mounting base, and/or a sliding door that is slidable so that at least a part of the side surface on which the mounting device is disposed has an opening to the outside when the mounting module is slid with respect to the mounting base.

13. The printing device according to Claim 12, wherein the housing has one or more access windows formed between the fabricating base and the fabricating module, the access windows allowing access to an inside of the fabricating base through the opening to the outside.

14. The printing device according to Claim 1 or 2,
wherein the housing includes a fabricating base serving as a pedestal and a fabricating module that is disposed above the fabricating base and accommodates the multiple units, and
multiple members are disposed inside the fabricating base such that heights of the multiple members tend to be lower as the multiple members are closer to the side surface accessible from outside.

15. The printing device according to Claim 1 or 2,
wherein the housing includes a fabricating base serving as a pedestal and a fabricating module that is disposed above the fabricating base and accommodates the multiple units, and
multiple cable racks are disposed inside the fabricating base such that disposition heights of the multiple cable racks tend to be lower as the multiple cable racks are farther from the side surface accessible from outside.

16. The printing device according to Claim 2,
wherein the first curing unit irradiates the fluid discharged onto the object with light having a predetermined wavelength to cure the fluid, and
the housing is provided with a shutter section configured to close and open the movement opening and block the light having the predetermined wavelength when closing the movement opening.

17. A printing system comprising:
the printing device according to Claim 1 or 2; and
the mounting device configured to mount a component on the fabricated object.
